# FASCICULE DE BREVET EUROPEEN

(11) **EP 3 714 544 B1**
(45) Date de publication et mention de la délivrance du brevet: **26.08.2026**
(21) Numéro de dépôt: 18852752.7
(22) Date de dépôt: 21.12.2018
(51) Int. Cl.: H03H 3/02, H03H 9/17, H03H 9/02, H10N 30/072, H10N 30/853

(54) **PROCEDE DE REALISATION D'UN RESONATEUR ACOUSTIQUE A ONDES DE VOLUME A CAPACITE PARASITE REDUITE**
VERFAHREN ZUR HERSTELLUNG EINES VOLUMENWELLENRESONATORS MIT REDUZIERTER PARASITÄRER KAPAZITÄT
METHOD FOR THE PRODUCTION OF A BULK ACOUSTIC WAVE RESONATOR WITH REDUCED PARASITIC CAPACITANCE

(30) Priorité: 26.12.2017 FR 1763228
(43) Date de publication de la demande: 30.09.2020
(73) Titulaire: Commissariat à l'Energie Atomique et aux Energies Alternatives, 75015 Paris (FR)
(72) Inventeur: GORISSE, Marie, 38500 VOIRON (FR); REINHARDT, Alexandre, 38400 SAINT-MARTIN D'HERES (FR); BENAISSA, Lamine, 91300 MASSY (FR); MOULET, Jean-Sébastien, 73000 CHAMBERY (FR)
(74) Mandataire: Santarelli
(86) Numéro de dépôt international: PCT/FR2018/053517
(87) Numéro de publication internationale: WO 2019/129979

(56) Documents cités:
- DE-A1- 10 315 239
- JP-A- 2008 154 240
- US-A1- 2003 199 105
- US-A1- 2009 265 903
- US-A1- 2013 119 491
- US-A1- 2018 294 790
- LAKIN K M: "Thin film resonator technology", IEEE TRANSACTIONS ON ULTRASONICS, FERROELECTRICS AND FREQUENCY CONTROL, vol. 52, no. 5, May 2005 (2005-05-01), pages 707 - 716, XP011367390
- ALEXANDRE REINHARDT ET AL: "Tunable composite piezoelectric resonators: A possible Holy Grail of RF filters?", 2012 IEEE MICROWAVE SYMPOSIUM DIGEST, June 2012 (2012-06-01), pages 1 - 3, XP032216797
- PIJOLAT M ET AL: "LiNbO3 Film Bulk Acoustic Resonator", 2010 IEEE INTERNATIONAL FREQUENCY CONTROL SYMPOSIUM, June 2010 (2010-06-01), pages 661 - 664, XP031738433

## Description

### DOMAINE TECHNIQUE ET ÉTAT DE LA TECHNIQUE ANTÉRIEURE

La présente invention se rapporte à un procédé de réalisation d'un résonateur à capacité parasite réduite, par exemple un résonateur acoustique à ondes de volume.

Par exemple, on souhaite réaliser des filtres radiofréquences (RF) ajustables, par exemple pour la téléphonie mobile, permettant de diminuer le nombre de filtres mis en œuvre dans un téléphone portable, en utilisant un même filtre pour adresser plusieurs bandes de fréquence.

De tels filtres RF existent déjà, il s'agit par exemple de filtres acoustiques à onde de volume ou filtre BAW (Bulk Acoustic Wave en terminologie anglo-saxonne), mais ils ne sont pas ajustables.

Un filtre acoustique à ondes de volume comporte une couche en matériau piézoélectrique, une électrode sur une face de la couche piézoélectrique et une électrode sur l'autre face. Afin de pouvoir maîtriser les propriétés du résonateur, les électrodes sont délimitées, par exemple par gravure ; elles ne couvrent donc pas toute la face de la couche piézoélectrique sur laquelle elles sont formées.

Afin d'obtenir un filtre acoustique à ondes de volume ajustable, un autre empilement, comportant une couche de matériau piézoélectrique et des électrodes de part d'autre de la couche piézoélectrique, est disposé sur l'empilement déjà réalisé, et isolé de celui-ci par un matériau isolant électrique.

Le premier empilement crée la résonance, il est appelé couche de transduction, et le deuxième empilement permet de modifier les conditions de propagation de l'onde générée par le premier empilement, il est appelé couche de pilotage (« tuning » en terminologie anglo-saxonne).

On cherche par ailleurs à exploiter, pour les couches de transduction et de pilotage, des ondes possédant un fort couplage électromécanique, par exemple pour permettre la synthèse de filtres passe-bande répondant aux exigences de la téléphonie mobile, d'une part, et une agilité en fréquence conséquente d'autre part. Ce fort couplage peut être obtenu en utilisant des matériaux présentant de fortes propriétés piézoélectriques. Par exemple le niobate de lithium ou LiNbO₃, également désigné par LNO, de coupe X, i.e. ayant une direction cristalline X perpendiculaire au plan du substrat, permet d'atteindre un couplage électromécanique théorique de 45% pour les modes visés. Une autre orientation cristalline intéressante est la coupe dite Y+163°, dans laquelle l'axe cristallin X est dans le plan, tandis que l'axe Y est incliné d'un angle de 163° par rapport à la normale au substrat. Cette orientation permet d'exciter des ondes possédant des coefficients de couplage électromécaniques inférieurs à la coupe X (de l'ordre de 35 %), mais ne permet d'exciter qu'une seule onde à la fois, ce qui conduit à une réduction du nombre de résonances parasites.

Dans une application à la téléphonie mobile, les fréquences recherchées sont de quelques centaines de MHz à quelques GHz. Pour cela les couches piézoélectriques doivent être très minces, par exemple de quelques centaines de nanomètres, l'épaisseur dépendant de la fréquence souhaitée.

Des couches de LNO à de telles épaisseurs et présentant une orientation cristalline donnée ne peuvent être réalisées par dépôt. La réalisation des deux empilements est alors obtenue soit par un transfert ou report par implantation, collage direct et fracture, soit par transfert ou report par collage direct et amincissement.

Afin que le filtre fonctionne correctement, les épaisseurs des deux empilements doivent conserver un rapport calculé en fonction des paramètres souhaités pour le résonateur. Or, au vu des épaisseurs recherchées qui sont de quelques centaines de nm, le dépôt de LNO présentant un axe cristallographique perpendiculaire au plan de l'empilement n'est pas envisageable. Des couches de LNO de quelques centaines de nm présentant cette orientation sont obtenues par implantation, collage direct et fracture.

Un tel filtre ajustable est actuellement réalisé à partir d'un premier, d'un deuxième et d'un troisième substrat.

Des étapes de réalisation d'électrodes sur les substrats, de collage des substrats et de fracture ont ensuite lieu.

L'empilement comporte quatre électrodes superposées. On définit la zone active du résonateur, la zone où les quatre électrodes se recouvrent. C'est à l'intérieur de cette zone que les ondes présentent le comportement attendu. Un très bon alignement des électrodes est recherché afin de maîtriser les caractéristiques électriques de l'empilement.

Du fait du procédé de réalisation, des désalignements s'accumulent entre les électrodes. Afin de disposer à la fin du procédé de réalisation d'une zone active de surface désirée, on prévoit des gardes au niveau des électrodes. Les électrodes ne présentent pas les mêmes dimensions que la zone active. En général c'est l'électrode réalisée en dernier qui présente les dimensions de la zone active. Les autres électrodes sont prévues avec une garde suffisante pour tenir compte des désalignements.

D'une part, ces gardes nuisent à la compacité du résonateur. D'autre part, il a été constaté que les portions des électrodes et du matériau piézoélectrique de la couche de pilotages en dehors de la zone active formaient l'équivalent d'une capacité parasite, qui est considérée comme branchée en parallèle d'une capacité externe utilisée pour piloter la fréquence de résonance du résonateur. Sa présence décale donc la consigne de pilotage de la fréquence. La plage d'agilité en fréquence du résonateur est alors limitée.

Le document de brevet US 2013/285248 A1 divulgue un procédé de réalisation d'un résonnateur acoustique comportant au moins un premier empilement fonctionnel et un deuxième empilement fonctionnel. Plus particulièrement, ce document décrit un procédé de collage de substrats au moyen d'empilements Ag/Sn ainsi que l'usage d'empilements Ag/Sn alternés et d'un recuit post-collage pour renforcer la liaison.

Le document de brevet US 2009/265903 A1 divulgue un procédé de fabrication d'un dispositif à résonateurs couplés, comprenant la formation d'un premier dispositif BAW sur un premier substrat, la formation d'un deuxième dispositif BAW sur un deuxième substrat et la liaison des premier et deuxième dispositifs BAW de telle sorte que les premier et deuxième dispositifs BAW liés soient pris en sandwich entre le premier et le deuxième substrat.

### EXPOSÉ DE L'INVENTION

C'est par conséquent un but de la présente invention d'offrir un nouveau procédé de réalisation d'une structure comportant deux empilements chacun comportant au moins un élément, les deux éléments étant alignés.

Le but précédemment énoncé est atteint par un procédé de réalisation d'une structure comportant un premier empilement comportant au moins un premier élément, un deuxième empilement comportant au moins un deuxième élément, le premier et le deuxième élément étant alignés, comportant la formation du deuxième élément sur le premier empilement de sorte qu'il soit aligné avec le premier élément, et le report par collage du reste du deuxième empilement.

Selon l'invention, l'alignement du premier et du deuxième élément est par exemple obtenu par lithographie et gravure et non par alignement d'une plaque par rapport à l'autre durant le report. L'alignement, lors d'une étape de lithographie, permet d'obtenir un alignement précis grâce à l'utilisation d'un aligneur de masque, ou même mieux, d'un photorépétiteur, utilisé en photolithographie, sans nécessiter le recours à une station d'alignement dédiée lors du collage.

C'est également un but de la présente invention d'offrir un procédé de réalisation d'un résonateur acoustique à ondes de volume offrant des capacités parasites réduites.

Le but précédemment énoncé est atteint par un procédé définit par les revendications.

### BRÈVE DESCRIPTION DES DESSINS

La présente invention sera mieux comprise sur la base de la description qui va suivre et des dessins en annexe sur lesquels:
- la figure 1 est une représentation schématique d'un exemple de filtre acoustique à ondes de volume ajustable obtenu par un exemple de procédé selon l'invention,
- les figures 2A à 2O sont des représentations schématiques des étapes d'un exemple du procédé de réalisation permettant de réaliser le filtre de la figure 1,
- la figure 3 est une représentation graphique des réponses électriques (l'impédance I en Ohm) en fonction de la fréquence en GHz d'un résonateur idéal et d'un résonateur R obtenu par le procédé selon l'invention,
- la figure 4 est une représentation graphique des réponses électriques (l'impédance I en Ohm) en fonction de la fréquence en GHz d'un résonateur idéal et d'un résonateur R' obtenu par un procédé de l'état de la technique,
- la figure 5A est une représentation d'une vue de dessus un filtre de la figure 1 obtenue avec le procédé selon l'invention, dans laquelle seuls les contours des électrodes sont représentés,
- la figure 5B est une représentation d'une vue de dessus d'un filtre onde acoustique de volume ajustable de l'état de la technique, dans laquelle seuls les contours des électrodes sont représentés,
- la figure 6 est une représentation graphique de la variation du coefficient de couplage électromécanique en % d'un résonateur acoustique ajustable, obtenu par un procédé selon l'invention en fonction de l'épaisseur h en nm de la couche intercalaire
- la figure 7 est une représentation graphique de la variation des fréquences de résonance et d'antirésonance en GHz en circuit ouvert et en court-circuit, de la couche de pilotage du résonateur acoustique ajustable obtenu par un procédé selon l'invention, en fonction de l'épaisseur de la couche intercalaire en nm,
- les figures 8A à 8J sont des représentations schématiques des étapes d'un exemple du procédé de réalisation permettant de réaliser un filtre SMR,
- les figures 9A à 9E sont des représentations schématiques des étapes d'un exemple du procédé de réalisation d'une structure comportant au moins un premier élément, un deuxième empilement comportant au moins un deuxième élément, le premier et le deuxième élément étant alignés.

### EXPOSÉ DÉTAILLÉ DE MODES DE RÉALISATION PARTICULIERS

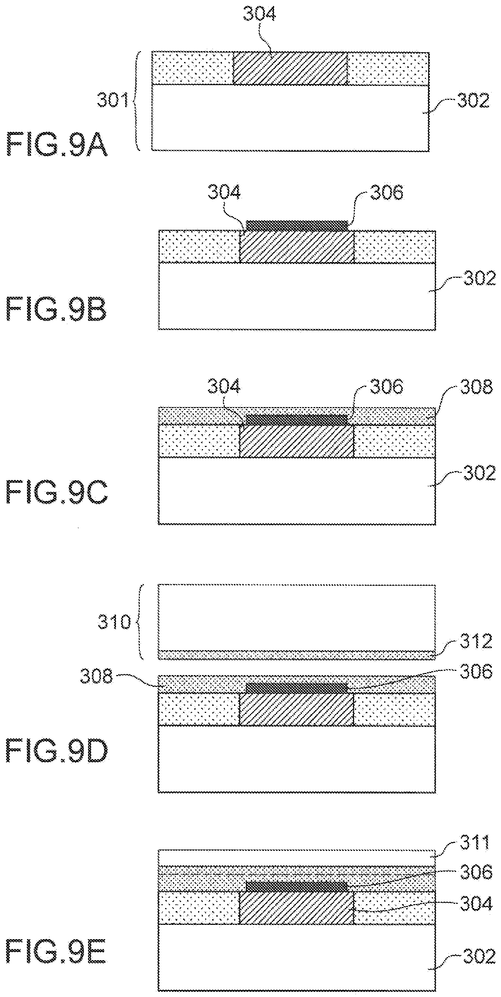

La description qui va suivre porte principalement mais non exclusivement sur un résonateur acoustique. La description des figures 9A à 9E porte sur la réalisation d'une structure plus générale comportant au moins un premier élément, un deuxième empilement comportant au moins un deuxième élément, le premier et le deuxième élément étant alignés.

Dans la présente demande, on entend par « portions alignées », les portions pouvant être des électrodes, le fait de réaliser une deuxième portion de matériau définie dans une couche à l'aplomb d'une première portion de matériau définie d'un empilement, de sorte que la distance entre le contour extérieur de la projection de la deuxième portion dans le plan de la première portion et le contour extérieur de la première portion soit inférieure à 2 µm, avantageusement inférieure à 500 nm, et encore plus avantageusement inférieure à 250 nm. L'expression « éléments alignés » est synonyme de « portions alignées ».

On entend par « portion définie » ou « électrode définie », une portion ou une électrode réalisée à partir d'une couche par photolithographie et gravure et présentant un contour extérieur, par opposition à une couche pleine plaque ou électrode pleine plaque qui s'étend sur tout l'empilement.

En outre on entend par « empilement fonctionnel », un empilement qui remplit une fonction, par exemple de manière non limitative, une fonction d'actionneur, une fonction de filtre, une fonction de transduction, une fonction de pilotage, une fonction de résonateur, une fonction de miroir de Bragg, une fonction de capteur, une fonction de circuit de lecture.

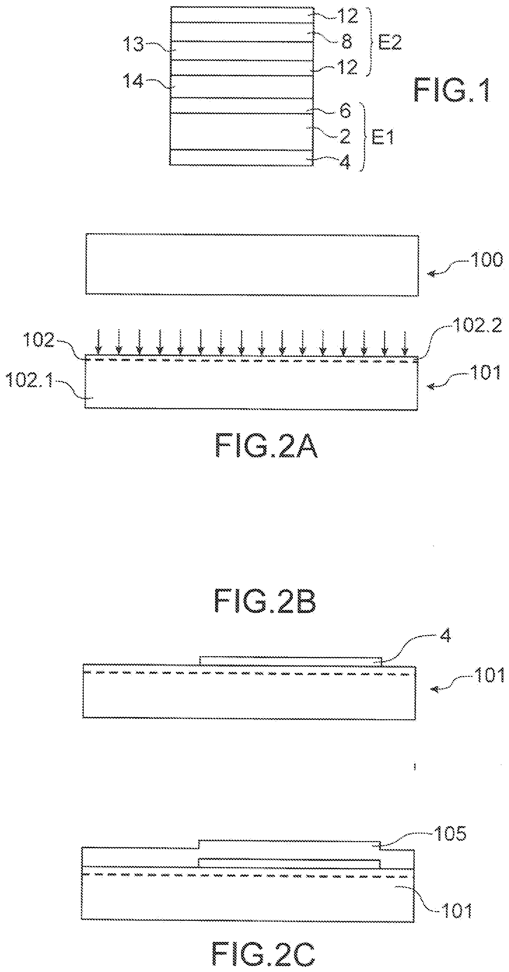

Sur la figure 1, on peut voir un exemple de réalisation d'un résonateur à ondes acoustique de volume ajustable selon l'invention comportant deux empilements E1, E2.

L'empilement E1 est désigné transducteur et comporte une couche 2 en matériau piézoélectrique, une électrode 4 sur une face de la couche 2 et une électrode 6 sur l'autre face de la couche 2. Les électrodes 4, 6 comportent une partie active destinée à la transduction et une ou des parties de contact destinée(s) à connecter la partie active à un circuit extérieur.

Les électrodes 4 et 6 sont définies et alignées au niveau de la zone active.

L'empilement E2 est désigné empilement de pilotage, il comporte une couche 8 en matériau piézoélectrique, une électrode 10 sur une face de la couche 8 et une électrode 12 sur l'autre face de la couche 8. Les électrodes 10 et 12 sont à l'aplomb l'une de l'autre et ont sensiblement la même surface, au niveau de la zone active.

L'empilement E2 comporte également une couche intercalaire 13 interposée entre l'électrode 10 et la couche piézoélectrique 8. Cette couche est une couche qui résulte du procédé de réalisation selon l'invention, et qui assure une fonction de collage. Comme nous le verrons par la suite cette couche 13 peut être interposée entre l'électrode 4 et la couche piézoélectrique 2 de l'empilement E1.

Les électrodes 10, 12 comportent une partie active destinée au pilotage et une ou des parties de contact destinée(s) à connecter la partie active à un circuit extérieur.

De manière préférentielle, le matériau piézoélectrique présente de fortes propriétés piézoélectriques, quantifiées par un « coefficient de couplage électromécanique » k² défini comme la fraction d'énergie convertie du domaine électrique au domaine mécanique, ou vice-versa, par rapport à l'énergie totale (électrique et élastique) disponible dans la structure. Le matériau piézoélectrique est par exemple choisi préférentiellement parmi le LiNbO₃, de préférence de coupes X ou Y+163°, désigné LNO, le LiTaO₃, ou le KNbO₃. De préférence, les couches 2 et 8 sont réalisées dans le même matériau piézoélectrique. En variante, les deux couches 2 et 8 peuvent être réalisées à partir de deux matériaux piézoélectriques différents, voire d'orientations cristallines différentes.

Les électrodes sont par exemple en tungstène ou en aluminium. Les électrodes peuvent être réalisées dans des matériaux conducteurs électriques différents.

Dans l'exemple représenté, l'empilement comporte un isolant électrique 14, par exemple du SiO₂, interposé entre les deux empilements E1 et E2, plus particulièrement entre les électrodes 6 et 10. Mais selon d'autres variantes, les électrodes 6 et 10 peuvent être confondues et ne former qu'une unique couche métallique.

Les électrodes présentent une surface inférieure à celle de la face de la couche piézoélectrique sur laquelle elles sont formées. Les électrodes sont par exemple réalisées par dépôt pleine plaque et gravure.

Grâce au procédé selon l'invention, la surface des parties des électrodes en dehors de la zone active du résonateur est sensiblement réduite, par rapport aux résonateurs de l'état de la technique, et la capacité parasite est de fait réduite. Le fonctionnement du filtre est alors amélioré.

Nous allons maintenant décrire un exemple du procédé de réalisation selon l'invention permettant de réaliser le résonateur de la figure 1.

Les étapes sont représentées sur les figures 2A à 2O.

Ce procédé permet de mettre en œuvre le LNO en couche mince comme matériau piézoélectrique. Dans la description qui va suivre le matériau piézoélectrique mis en œuvre est le LNO, mais le procédé peut mettre en œuvre d'autres matériaux piézoélectriques.

Les couches minces de LNO ont par exemple une épaisseur entre une centaine de nm et quelques centaines de nanomètres. L'épaisseur de LNO est choisie en fonction de la plage de fréquences recherchée. En outre il est préférable que le LNO ait une orientation cristalline donnée : de préférence on souhaite disposer d'une couche de LNO coupe X.

Or, contrairement à l'AIN, qui est le matériau utilisé de manière conventionnelle dans l'industrie des filtres à ondes de volume, mais qui présente des propriétés piézoélectriques insuffisantes pour une application de filtre agile en fréquence, la réalisation de couches minces de LNO par dépôt n'est pas envisageable.

Dans une première phase, on réalise l'empilement destiné à former le transducteur. En variante, le procédé pourrait débuter par la formation de l'empilement destiné au pilotage. Pour cela on utilise un substrat 100 par exemple en silicium, et un substrat 101, par exemple en LNO.

Lors d'une première étape, on réalise dans le substrat 101, une implantation ionique afin de créer une zone fragilisée 102 à une profondeur prédéterminée. La zone fragilisée est schématisée par une ligne interrompue. La zone fragilisée 102 est réalisée à une profondeur légèrement supérieure à l'épaisseur souhaitée de la couche de LNO dans l'empilement, par exemple de l'ordre de 50 à 200 nm de plus que l'épaisseur finale visée. La face du substrat 101 la plus proche de la zone fragilisée est désignée face avant. La zone fragilisée 102 délimite le substrat en deux parties 102.1 et 102.2, la partie 102.2 étant destinée à former la couche fine de LNO.

L'élément ainsi obtenu est représenté sur la figure 2A.

Lors d'une étape suivante on forme une couche métallique, par exemple en aluminium, en tungstène, en platine ou en molybdène sur la face avant du substrat 101, par exemple par dépôt par pulvérisation cathodique, afin de réaliser une électrode. Ensuite la couche métallique est structurée par exemple par photolithographie pour réaliser l'électrode définie 4.

L'élément ainsi obtenu est représenté sur la figure 2B.

Lors d'une étape suivante, on forme une couche sacrifiée 105 sur l'électrode 4 et la face avant, par exemple par dépôt de silicium amorphe par pulvérisation cathodique.

L'élément ainsi obtenu est représenté sur la figure 2C.

Lors d'une étape suivante, on structure la couche sacrifiée 105 de silicium amorphe, par exemple par gravure ionique réactive utilisant des gaz fluorés, par exemple SF₆ et/ou CH₂F₂). Ceci forme un caisson, qui correspond à la localisation de la future membrane suspendue.

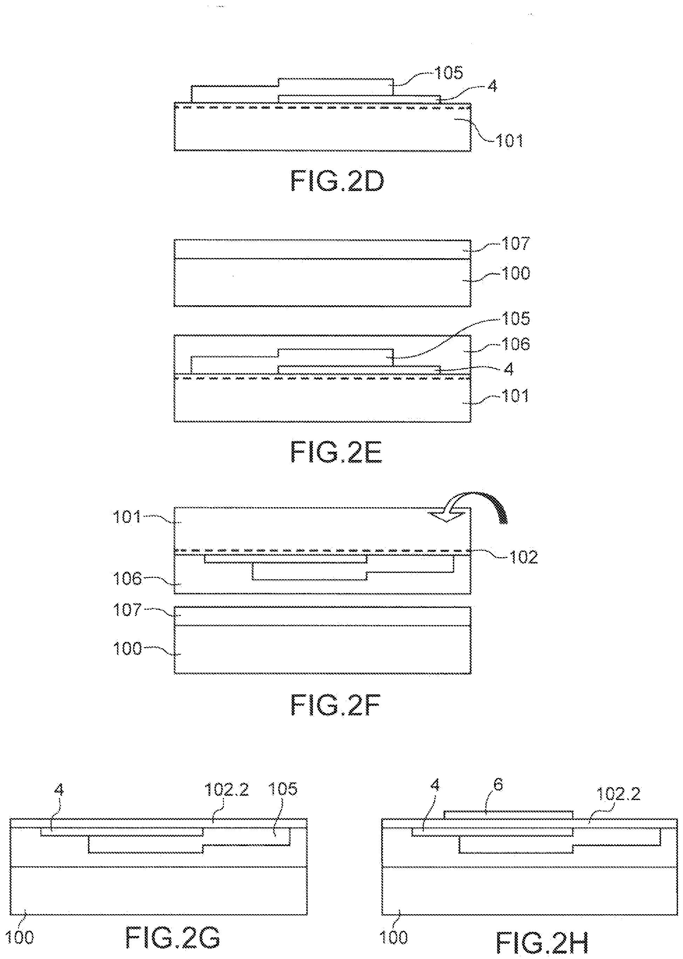

L'élément ainsi obtenu est représenté sur la figure 2D.

Lors d'une étape suivante, on forme une couche de collage 106, par exemple en SiO₂, sur la face avant et la couche sacrifiée 105.

Sur le substrat 100, on forme également une couche de collage 107, par exemple en SiO₂.

Une étape de planarisation des couches de collage 106 et 107 peut ensuite avoir lieu, par exemple par polissage mécano-chimique.

L'élément ainsi obtenu est représenté sur la figure 2E.

Lors d'une étape suivante, on procède à l'assemblage des deux substrats par mise en contact de couches de collage 106 et 107, l'assemblage est par exemple obtenu par collage direct. En variante, l'assemblage peut être obtenu par collage polymère : après formation de caissons de couche sacrifiée, on procède à l'étalement par centrifugation d'une résine, par exemple du BCB (bisbenzocyclobutene). On procède ensuite à la mise en contact des deux substrats dans un équipement d'alignement plaque à plaque, et enfin à un recuit permettant à la résine de polymériser et de se durcir.

L'élément ainsi obtenu est représenté sur la figure 2F.

Lors d'une étape suivante, on fracture la couche de LNO au niveau de la zone d'implantation 102, de sorte à retirer la partie 102.1.

On obtient alors un élément avec une couche fine 102.2 de LNO et une électrode 4 sur l'une de ses faces.

Un polissage peut ensuite avantageusement être réalisé afin d'amener l'épaisseur de la couche à la valeur visée.

L'élément ainsi obtenu est représenté sur la figure 2G.

En variante, la couche fine de LNO peut être obtenue par amincissement du substrat 100 jusqu'à l'épaisseur souhaitée, par polissage sans recourir à une étape d'implantation.

Lors d'une étape suivante, on forme une couche de matériau conducteur sur la couche fine 102.2 de LNO, et on structure la couche de sorte à former l'électrode définie 6 alignée avec l'électrode 4. Par exemple, lors d'une étape de photolithographie et d'un aligneur de masque, on délimite l'électrode 6 de sorte qu'elle soit alignée avec l'électrode 4. Ensuite par gravure, on définit l'électrode 6. Cet alignement est rendu possible du fait du caractère transparent du substrat et de la couche d'oxyde séparant le substrat des électrodes.

L'élément ainsi obtenu est représenté sur la figure 2H.

Lors d'une étape suivante, on forme une couche de matériau isolant électrique 110, par exemple du SiO₂, sur l'électrode 6 en vue de la réalisation de l'empilement de pilotage. La couche est formée sur toute la face avant de l'élément. Cette couche est destinée à isoler électriquement l'empilement de transduction E1 et l'empilement de pilotage E2.

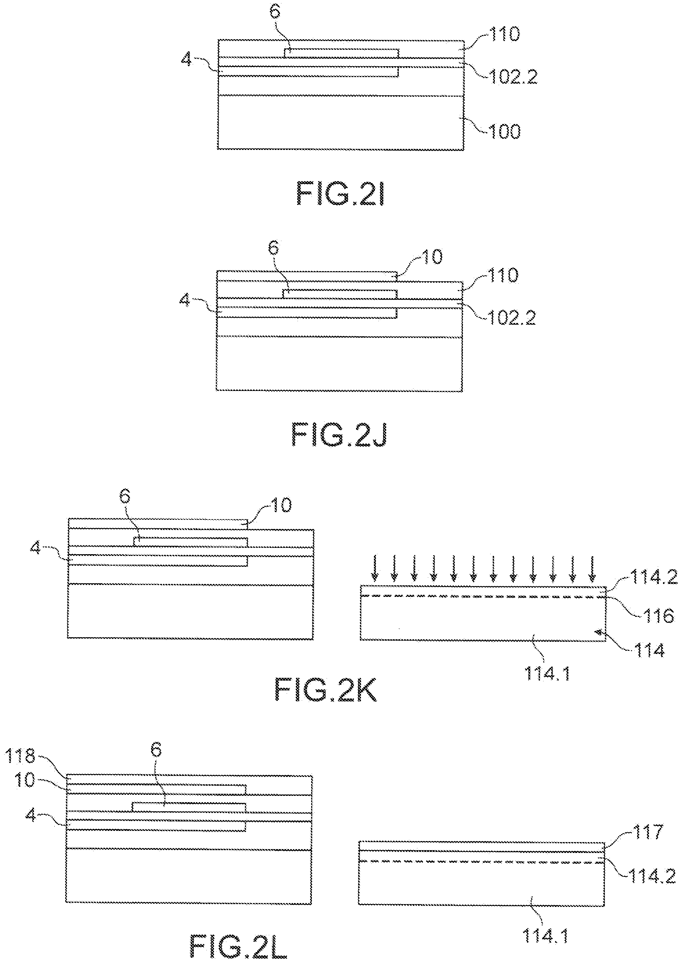

L'élément ainsi obtenu est représenté sur la figure 2I.

Lors d'une étape suivante, on dépose une couche en un matériau conducteur électrique sur la couche 110, et on structure l'électrode 10, de sorte qu'elle soit alignée avec les électrodes 4, 6.

Cet alignement peut avantageusement être obtenu, par exemple par photolithographie et un aligneur de masque, comme cela a été décrit ci-dessus pour la réalisation de l'électrode 6. La couche est ensuite gravée pour définir l'électrode 10.

Une étape de retrait de résine, ou stripping en terminologie anglo-saxonne, peut ensuite avoir lieu.

L'élément ainsi formé est représenté sur la figure 2J.

Par ailleurs on réalise, dans un troisième substrat 114 en LNO, une implantation ionique afin de créer une zone fragilisée 116 à une profondeur prédéterminée. La zone fragilisée est schématisée par une ligne interrompue. La profondeur de la zone fragilisée va définir l'épaisseur de la couche de LNO dans l'empilement de pilotage. La face du substrat la plus proche de la zone fragilisée est désignée face avant. La zone fragilisée délimite le substrat en deux parties 114.1 et 114.2, la partie 114.2 étant destinée à former la couche fine de LNO. L'élément ainsi obtenu est représenté sur la figure 2K.

Selon un autre exemple le substrat 114 peut être réalisé dans un matériau piézoélectrique différent du LNO.

On forme ensuite une couche 118 en matériau isolant électrique par exemple en SiO₂, sur l'électrode 10. Une étape de planarisation a avantageusement lieu, par exemple par polissage mécano-chimique.

L'élément D2 ainsi obtenu est représenté sur la figure 2L.

Lors d'une étape suivante, on forme une couche 117 en matériau isolant électrique sur la face avant du substrat 114, par exemple en SiO₂. Une étape de planarisation a avantageusement lieu, par exemple par polissage mécano-chimique en vue du collage sur l'élément D2.

L'élément D1 est ainsi formé.

Les éléments D1 et D2 sont représentés sur la figure 2L.

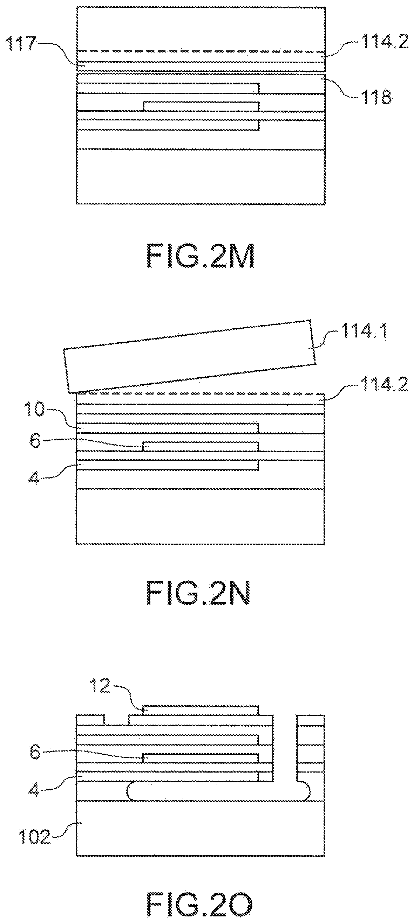

Lors d'une étape suivante, on assemble les éléments D1 et D2 par les couches 118 et 117, par exemple par collage direct. Cette étape d'assemblage ne requiert aucun alignement car l'élément D1 ne comporte aucune électrode. Les épaisseurs des couches 117 et 118 sont choisies de sorte que, lors de l'assemblage, l'épaisseur totale corresponde à l'épaisseur souhaitée de matériau isolant électrique entre les deux empilements. L'élément ainsi obtenu est représenté sur la figure 2M.

Lors d'une étape suivante, on retire la partie 114.1 de LNO par fracturation.

En variante, pour former la couche fine de LNO, le substrat 114 est aminci par polissage, sans recourir à une étape d'implantation.

L'élément ainsi obtenu est représenté sur la figure 2N.

Lors d'une étape suivante on forme une couche en matériau conducteur électrique, par exemple par dépôt, sur la couche fine 114.2 de LNO.

Par exemple, par une photolithographie et au moyen d'un aligneur de masque on délimite l'électrode définie 12, de sorte à ce qu'elle soit alignée avec l'électrode 10, et ensuite par une étape de gravure on forme l'électrode 12.

Dans l'exemple représenté et de manière non limitative, on réalise en outre des gravures successives de la couche piézoélectrique 114.2 et de la couche isolante 110, et enfin de la couche piézoélectrique 114.2, de la couche isolante 110 et de la couche piézoélectrique 102.2, toutes trois par exemple par usinage ionique, afin de reprendre des contacts électriques respectivement sur les électrodes 10, 6 et 4. Pour finir, une gravure de tout l'empilement avec arrêt dans la couche sacrifiée 105, toujours par exemple par usinage ionique, suivi d'une gravure en phase gazeuse de la couche sacrifiée 104, par exemple une gravure par XeF2 d'un caisson en silicium amorphe, permet de libérer les résonateurs suspendus au-dessus d'une lame d'air.

L'élément ainsi obtenu est représenté sur la figure 2O.

Ce procédé peut être mis en œuvre pour réaliser un résonateur SMR.

Grâce à ce procédé, on évite de devoir réaliser un alignement entre deux plaques lors du collage afin d'aligner les différents niveaux d'électrodes entre eux, les alignements étant obtenus par un aligneur de masque ou un photorépétiteur lors de la lithographie, ce qui est plus simple et surtout beaucoup plus précis. Ce procédé permet de diminuer le coût de fabrication, puisqu'il ne nécessite pas le recours à une station d'alignement dédiée lors du collage.

Le procédé de réalisation selon l'invention permet d'obtenir un alignement précis des électrodes, ce qui permet de diminuer la marge habituellement prise lors de la conception des structures pour pallier un désalignement éventuel.

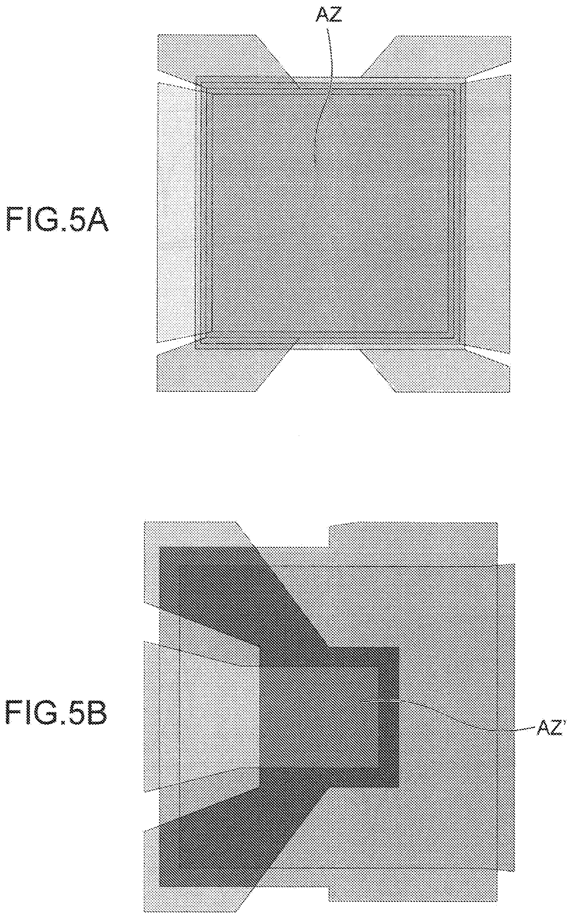

Grâce à l'invention, en supposant des alignements réalisés à l'aide de photorépétiteurs, il est possible d'envisager des gardes pour combler des désalignements de l'ordre de 1 µm entre chaque niveau métallique, ce qui inclut des incertitudes d'alignement entre niveau et les pertes de côte liées aux étapes de lithographie et de gravure. Sur la figure 5A, on peut voir une représentation d'une vue de dessus un résonateur obtenue avec le procédé selon l'invention, dans laquelle seuls les contours des électrodes sont représentés, la zone active du résonateur, qui correspond à la zone commune des quatre électrodes, est désignée AZ. Les gardes sont très réduites. Sur la figure, on peut voir une représentation d'une vue de dessus d'un filtre onde acoustique de volume ajustable de l'état de la technique, dans laquelle seuls les contours des électrodes sont représentés. La zone commune des quatre électrodes, est désignée AZ'

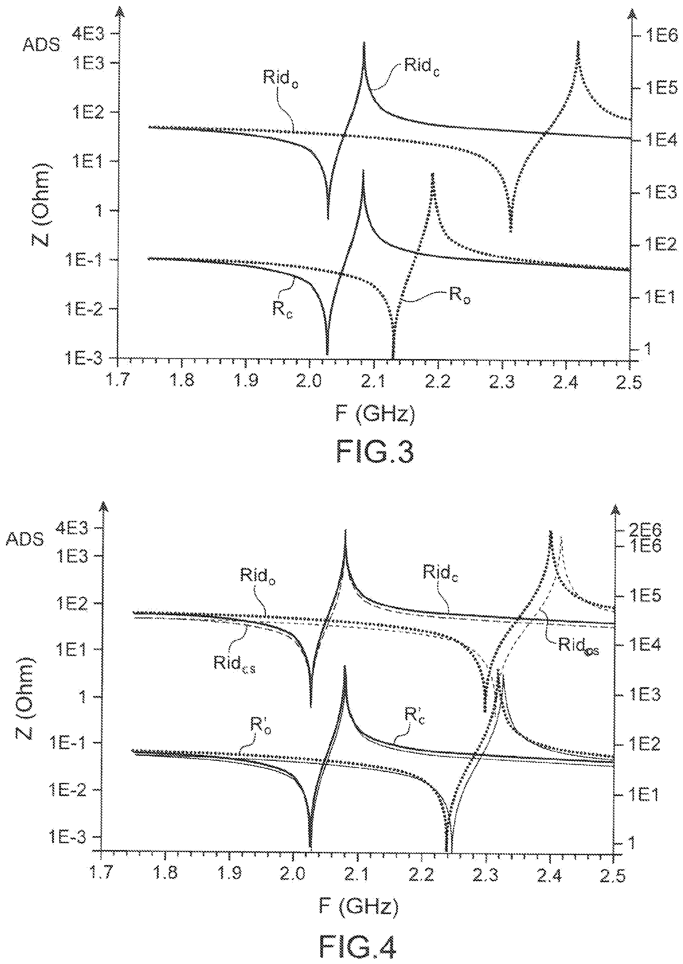

Sur la figure 3, on peut voir représentées les réponses électriques (l'impédance Z en Ohm) en fonction de la fréquence d'un résonateur idéal Rid et d'un résonateur R obtenu selon l'invention, comportant une couche intercalaire 13 de 60 nm d'épaisseur. La courbe Rido est la réponse électrique lorsque la couche piézoélectrique de pilotage est en circuit ouvert, et la Rldc est la réponse électrique lorsque la couche piézoélectrique de pilotage est en court-circuit.

La courbe Ro est la réponse électrique lorsque la couche piézoélectrique de pilotage est en circuit ouvert, et la Rc est la réponse électrique lorsque la couche piézoélectrique de pilotage est en court-circuit.

Sur la figure 4 on peut voir représenté, à titre de comparaison, la réponse électrique d'un résonateur R' de l'état de la technique dont l'extension des électrodes hors de la zone active correspond à une surface de 1,5 fois la zone active. Il présente donc une forte capacité parasite.

La courbe R'o est la réponse électrique lorsque la couche piézoélectrique de pilotage est en circuit ouvert, et la R'c est la réponse électrique lorsque la couche piézoélectrique de pilotage est en court-circuit.

Les courbes en pointillés Ridos et Ridcs correspondent aux empilements théoriques présentant les alignements obtenus grâce à la présente invention mais ne mettant pas en œuvre de couches de collage. On constate que la présence d'une couche de collage n'a pas d'effet trop important sur le fonctionnement du résonateur.

Les conditions en circuit ouvert et en court-circuit représentent les deux positions extrêmes atteignables par le résonateur agile en fréquence.

On constate que l'agilité en fréquence du résonateur obtenu par le procédé selon l'invention est réduite par rapport à celle d'un résonateur idéal, mais cette réduction est nettement inférieure à celle du résonateur R' de l'état de la technique. Par conséquent grâce à l'invention on peut réaliser des filtres acoustiques à ondes de volume ajustables présentant une agilité en fréquence étendue par rapport à ceux de l'état de la technique.

De plus, du fait du procédé selon l'invention, l'empilement obtenu par le procédé décrit ci-dessus comporte une couche de collage entre un des matériaux piézoélectriques et une électrode. Or cette couche, qui est généralement en SiO₂, est isolante électrique.

Les filtres de l'état de la technique ne comportent pas une telle couche. On souhaite habituellement mettre en contact les électrodes directement avec la couche piézoélectrique. Or les inventeurs ont découvert que la présence de cette couche était acceptable pour le fonctionnement du résonateur ajustable.

Afin d'évaluer l'effet de la présence de cette couche intercalaire sur le fonctionnement du filtre des mesures ont été faites, en considérant le filtre suivant :
Les électrodes 4, 6, 10, 12 sont en Al chacune d'épaisseur 100 nm.

La couche piézoélectrique de pilotage est en LNO de 650 nm d'épaisseur.

La couche du transducteur est en LNO de 625 nm d'épaisseur.

La couche d'isolation électrique en les deux empilements est en SiO₂ de 200 nm d'épaisseur et la couche de collage est en SiO₂ d'épaisseur h

frO et faO désignent les fréquences de résonance et d'antirésonance lorsque l'empilement de pilotage est en circuit ouvert et frF et faF désignent les fréquences de résonance et d'antirésonance lorsque l'empilement de pilotage est en circuit fermé.

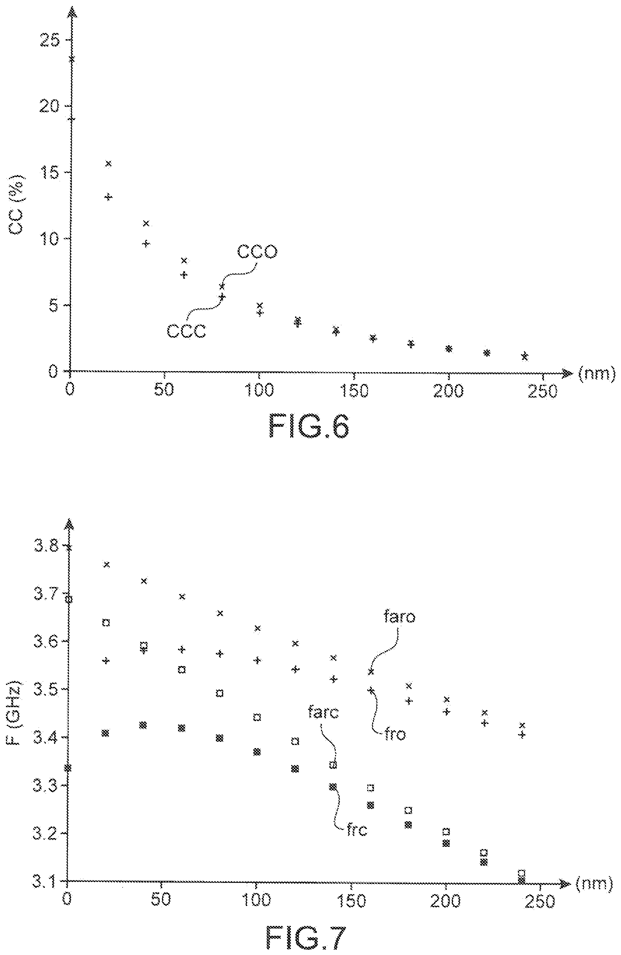

La figure 6 représente la variation du coefficient de couplage électromécanique cc en % en fonction de l'épaisseur h en nm. cco désigne le coefficient de couplage électromécanique en circuit ouvert et ccc désigne le coefficient de couplage électromécanique en court-circuit.

Le coefficient de couplage électromécanique représente la capacité du matériau piézoélectrique à convertir l'énergie électrique en énergie mécanique et vice-versa. Pour une application de filtrage, ce coefficient est proportionnel à l'écart relatif entre les fréquences de résonance et d'antirésonance du résonateur, et par conséquent renseigne sur les bandes passantes relatives qu'il est possible d'atteindre.

On constate que le coefficient cc diminue rapidement lorsque l'épaisseur de la couche intercalaire augmente. Il serait préférable de choisir une épaisseur h au plus de 60 nm qui est suffisante pour assurer le collage. Mais dans certaines conditions, une telle épaisseur peut rendre complexe la planarisation avant collage.

En première approximation, le coefficient cc est proportionnel au rapport épaisseur entre la couche piézoélectrique et l'épaisseur totale.

Sur la figure 7, on peut voir représentée la variation des fréquences de résonance fr et d'antirésonance far en GHz en circuit ouvert fro et faro et en court-circuit frc et farc de la couche de pilotage, en fonction de l'épaisseur de la couche intercalaire 13 en nm. Il est à noter que les empilements utilisés pour les mesures de la figure 7 sont différents de ceux utilisés pour la figure 3.

On constate que la différence de fréquence entre les fréquences de résonance en circuit ouvert et la différence de fréquence entre les fréquences d'antirésonance en court-circuit augmente avec l'épaisseur de la couche intercalaire. Ainsi l'agilité du filtre augmente avec l'épaisseur. Par conséquent, on peut compenser la diminution du coefficient de couplage cc, voire augmenter celui-ci, en modifiant le rapport des épaisseurs entre la couche de pilotage et la couche de transduction, tout en conservant l'agilité initiale du filtre.

A l'inverse, si la couche intercalaire est localisée contre la couche de transduction, un effet similaire conduit à une augmentation du coefficient de couplage électromécanique du résonateur.

Grâce au procédé selon l'invention mettant en œuvre une couche de collage entre une électrode et la couche piézoélectrique, on réduit les capacités parasites tout en modifiant peu, voire en ne modifiant pas, le couplage entre la couche de pilotage et la couche de transduction.

En outre, la couche de collage peut avantageusement améliorer le comportement du résonateur en température. En effet, le LNO est un matériau présentant une dérive en température élevée. Les résonateurs mettant en œuvre du LNO sont donc très sensibles à la température. La présence de la couche de collage, par exemple en SiO₂, entre l'électrode et le LNO assure une compensation en température au moins partielle et rend le résonateur moins sensible à la température.

Selon un autre exemple de réalisation le procédé selon l'invention permet de réaliser des résonateurs acoustiques à ondes de volume sur miroirs de Bragg, dits SMR (Solidly Mounted Resonators en terminologie anglo-saxonne) qui utilisent un miroir de Bragg acoustique pour assurer un découplage mécanique entre le résonateur et le substrat.

La cavité d'air présente dans le résonateur ajustable de la figure 2O, est remplacée par un empilement de couches alternativement haute et basse impédance acoustique.

De manière conventionnelle, ces miroirs sont généralement réalisés en utilisant des couches de SiO₂ comme matériau à basse impédance acoustique, et de métaux denses, par exemple du W, Mo, ... comme matériau à haute impédance acoustique. Or les couches métalliques peuvent former de capacités parasites lorsqu'elles courent sous des pistes électriques. Grâce au procédé selon l'invention, il est possible de les définir de manière à réduire les zones de couches métalliques qui ne sont pas à l'aplomb du résonateur.

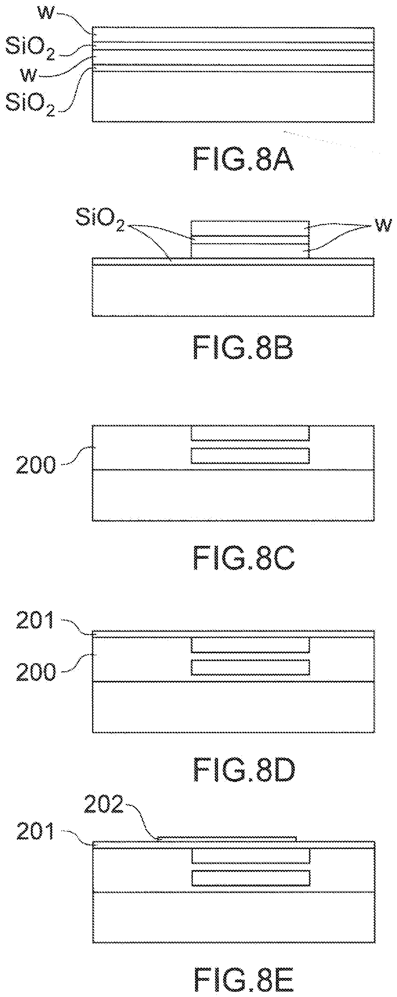

Un exemple de procédé selon l'invention permettant de réaliser un résonateur SMR va maintenant être décrit à l'aide des figures 8A à 8J.

Lors d'une première étape on réalise un empilement de SiO₂/W/SiO₂/W destiné à former le miroir de Bragg, par une succession de dépôts par PECVD (*Plasma Enhanced Chemical Vapor Deposition*). On pourrait aussi réaliser des dépôts successifs de SiO₂ et de Mo par pulvérisation par exemple.

L'élément ainsi obtenu est représenté sur la figure 8A.

Lors d'une étape suivante on réalise une structuration du miroir, par exemple par photolithographie, gravure sèche de trois couches de W/SiO₂/W.

L'élément ainsi obtenu est représenté sur la figure 8B.

Lors d'une étape suivante, on forme une couche de SiO₂ 200, et on réalise ensuite une étape de planarisation.

L'élément ainsi obtenu est représenté sur la figure 8C.

Lors d'une étape suivante, on forme une autre couche de SiO₂ 201, et on

L'élément ainsi obtenu est représenté sur la figure 8D.

Lors d'une étape suivante, on forme une couche conductrice électrique 202 sur la couche 200, par exemple en Mo. Cette couche est ensuite structurée pour former une première électrode définie, par exemple par photolithographie, gravure sèche et retrait de résine.

L'élément ainsi obtenu est représenté sur la figure 8E.

Lors d'une étape suivante, on forme une couche de de SiO₂ 204 sur la première électrode, destinée au collage avec un substrat de LNO. Une étape de planarisation peut avoir lieu.

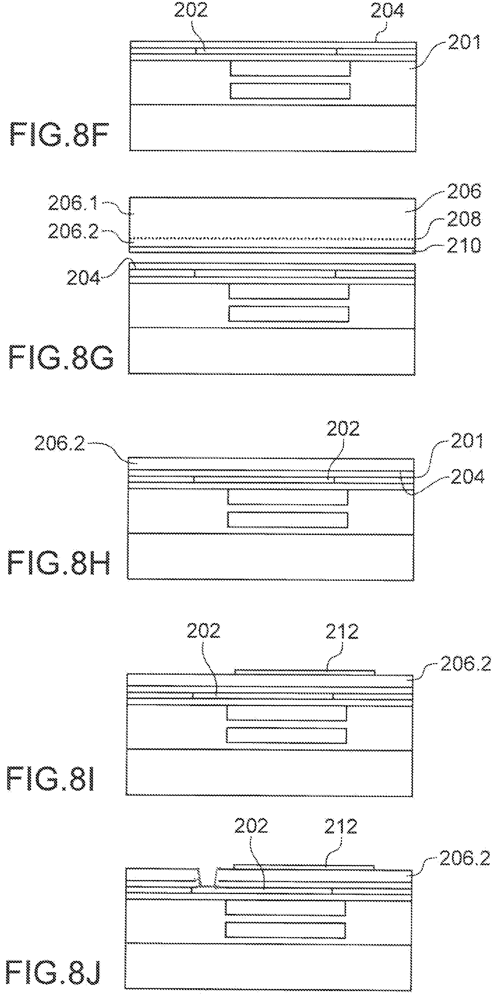

L'élément ainsi obtenu est représenté sur la figure 8F.

Par ailleurs, on réalise une implantation ionique d'un substrat 206 en LNO afin de créer une zone fragilisée 208 à une profondeur prédéterminée. La zone fragilisée est schématisée par une ligne interrompue. La profondeur de la zone fragilisée va définir l'épaisseur de la couche de LNO du résonateur. La face du substrat la plus proche de la zone fragilisée est désignée face avant. La zone fragilisée délimite le substrat en deux parties 206.1 et 206.2, la partie 206.2 étant destinée à former la couche fine de LNO.

Une couche de SiO₂ 210 est ensuite formée sur la face avant du substrat 206 pour le collage avec l'élément. Une étape de planarisation peut avoir lieu, suivi d'une activation de surface pour favoriser l'étape de collage ultérieure.

L'élément ainsi obtenu est représenté sur la figure 8G.

Lors d'une étape suivante les deux éléments sont assemblés par collage de couches 204 et 210, par exemple par collage direct. On procède ensuite à un recuit de renforcement, suivi d'un recuit de fracturation. Le substrat 206.1 est retiré. Une étape de planarisation et/ou un recuit de guérison, destiné à guérir les défauts générés par l'implantation et la fracture dans la couche reportée, peuvent avoir lieu.

L'élément ainsi obtenu est représenté sur la figure 8H.

Lors d'une étape suivante, on forme une couche en matériau conducteur électrique 212, par exemple en Mo, par exemple par pulvérisation.

Par exemple par une photolithographie et au moyen d'un aligneur de masque, on délimite la deuxième électrode définie de sorte à ce qu'elle soit alignée avec la première électrode, et ensuite par une étape de gravure, par exemple une gravure sèche, on forme la deuxième électrode.

L'élément ainsi obtenu est représenté sur la figure 8I.

Lors d'une étape suivante, on structure la couche de LNO par photolithographie, gravure par faisceau d'ion, puis retrait de résine.

L'élément ainsi obtenu est représenté sur la figure 8J.

Grâce au procédé selon l'invention, les portions des couches conductrices du miroir qui ne sont pas à l'aplomb des électrodes du résonateur sont minimisées. Les parasites électriques sont ainsi réduits.

Sur les figures 9A à 9E, on peut voir un exemple de procédé selon l'invention de réalisation d'une structure qui comporte au moins un premier empilement et un deuxième empilement.

Par exemple, le premier et le deuxième empilement sont chacun un actionneur. En variante, l'un des empilements est un actionneur, et l'autre empilement est une structure à déplacer.

Selon un exemple, la structure peut être mise en œuvre dans un détecteurs pyroélectrique, le premier empilement peut alors être le capteur pyroélectrique, et le deuxième empilement peut être le circuit de lecture. Selon un autre exemple, la structure peut être mise en œuvre dans un système microélectronique, chaque empilement peut être un circuit.

Le premier empilement 301 comporte un premier élément ou structure 304 et une première partie 302 destinés à coopérer ensemble, et le deuxième empilement 310 comporte un deuxième élément ou une deuxième structure 306 et une deuxième partie 311 destinés à coopérer ensemble, le premier élément 304 étant aligné avec le deuxième élément 306.

On part par exemple d'un premier empilement 301 (figure 9A) comportant un substrat 302, dit substrat receveur, et d'une structure définie 304 formée sur ce substrat.

Lors d'une première étape on forme un élément ou structure 306 sur la structure 304 de sorte que les deux structures 304 et 306 soient alignées. Cette formation est faite par exemple par dépôt et photolithographie

L'élément ainsi obtenu est représenté sur la figure 9B.

Lors d'une étape suivante, on forme une couche de collage 308, par exemple en SiO₂, sur la face avant de l'élément de la figure 9B.

L'élément ainsi obtenu est représenté sur la figure 9C.

Sur un deuxième empilement 310 comportant un substrat 311, dit substrat donneur, ne comportant par la structure 306, on forme également une couche de collage 312, par exemple en SiO₂.

Une étape de planarisation des couches de collage 308 et 312 peut ensuite avoir lieu, par exemple par polissage mécano-chimique.

L'élément ainsi obtenu est représenté sur la figure 9D.

Lors d'une étape suivante, on procède à l'assemblage des deux substrats par mise en contact de couches de collage 308 et 310, l'assemblage est par exemple obtenu par collage direct. En variante, l'assemblage peut être obtenu par collage polymère, on procède à l'étalement par centrifugation d'une résine, par exemple du BCB (bisbenzocyclobutene). On procède ensuite à la mise en contact des deux substrats dans un équipement d'alignement plaque à plaque, et enfin à un recuit permettant à la résine de polymériser et de se durcir.

Lors d'une étape suivante, on peut réduire l'épaisseur du substrat 311, par exemple par fracture au niveau d'une zone d'implantation.

Un polissage peut ensuite avantageusement être réalisé afin d'amener l'épaisseur de la couche à la valeur visée.

L'élément ainsi obtenu est représenté sur la figure 9E.

En variante, le substrat 311 peut être aminci par polissage sans recourir à une étape d'implantation.

Ce procédé permet, à titre d'exemple, de réaliser des actionneurs, des détecteurs par exemple pyroélectriques, des systèmes microélectroniques...

En outre le procédé de réalisation selon l'invention ne nécessite pas de réaliser sur des plaques implantées des étapes (principalement de dépôt) nécessitant des budgets thermiques élevés. Il est donc possible de disposer de couches métalliques ou isolantes déposées à température élevées et donc possédant de faibles pertes acoustiques, ce qui n'était pas possible selon les techniques connues de l'état de l'art. En outre, il ne génère pas des contraintes cumulées relativement élevées dans les empilements.

La présente invention s'applique également à la réalisation d'une structure comportant un empilement avec plusieurs éléments dans un plan alignés chacun avec un élément de l'autre empilement.

## Revendications

1. Procédé de réalisation d'un résonateur acoustique comportant au moins un premier empilement (E1) fonctionnel et un deuxième empilement (E2) fonctionnel, le premier empilement fonctionnel comportant au moins un premier élément (2, 4, 6) composé d'une première couche de matériau piézoélectrique (2) interposée entre deux couches conductrices électriques (4, 6) alignées, le deuxième empilement fonctionnel comportant au moins un second élément (8, 10, 12) composé d'une seconde couche de matériau piézoélectrique (8) interposée entre une première et une deuxième électrode (1à, 12), ledit procédé comportant :
- fourniture d'un premier empilement fonctionnel comportant la première couche de matériau piézoélectrique ainsi que les deux couches conductrices électriques associées,
- formation de la première électrode du second empilement fonctionnel sur le premier empilement fonctionnel, de sorte à aligner la première électrode avec les deux couches conductrices électriques, et formation d'une première couche de collage (118) en matériau isolant électrique sur la première électrode,
- fourniture d'une partie du deuxième empilement fonctionnel comprenant au moins une deuxième couche de collage (117) en matériau isolant électrique et la seconde couche de matériau piézoélectrique,
- assemblage du premier empilement fonctionnel et de la partie du deuxième empilement fonctionnel comprenant au moins une deuxième couche de collage et la seconde couche de matériau piézoélectrique en mettant en contact les première et deuxième couches de collage,
- formation de la seconde électrode du second empilement fonctionnel, de sorte à définir la seconde électrode en alignement avec les deux couches électriques conductrices,
une deuxième entité étant dite alignée avec une première entité définie d'un empilement lorsque, la deuxième entité étant définie dans une couche à l'aplomb de la première entité, une distance entre un contour extérieur d'une projection de la deuxième entité dans un plan de la première entité et un contour extérieur de la première entité est inférieure à 2 µm.

2. Procédé de réalisation selon la revendication 1, dans lequel l'assemblage entre le premier empilement fonctionnel et la partie du deuxième empilement fonctionnel est un collage direct.

3. Procédé de réalisation selon la revendication 1 ou 2, dans lequel les couches de collage sont en un matériau diélectrique.

4. Procédé de réalisation selon l'une des revendications 1 à 3, dans lequel les première (118) et deuxième (117) couches de collage sont telles qu'elles forment une couche intercalaire (13) d'épaisseur comprise entre 10 nm et 50 nm.

5. Procédé de réalisation selon l'une des revendications 1 à 4, dans lequel l'alignement de la première électrode avec les deux couches conductrices électriques et la réalisation de la deuxième électrode de sorte à définir la seconde électrode en alignement avec les deux couches électriques conductrices sont obtenues en mettant en œuvre un aligneur de masque ou un photorépétiteur lors d'une étape de photolithographie.

6. Procédé de réalisation selon l'une des revendications précédentes, dans lequel le deuxième empilement est un transducteur et le premier empilement comportant la première couche en matériau piézoélectrique forme des moyens de pilotage en fréquence dudit transducteur.

7. Procédé de réalisation selon la revendication 6, comportant, avant la formation de la deuxième électrode, une étape de retrait d'une portion d'épaisseur donnée de la deuxième couche en matériau piézoélectrique du deuxième empilement jusqu'à une épaisseur donnée.

8. Procédé de réalisation selon la revendication précédente, dans lequel l'étape de retrait d'une portion d'épaisseur donnée de la deuxième couche en matériau piézoélectrique) est obtenue par fracturation de la deuxième couche en matériau piézoélectrique du deuxième empilement, ladite deuxième couche en matériau piézoélectrique ayant préalablement subi une implantation ionique à une profondeur légèrement supérieure à l'épaisseur donnée de la première couche en matériau piézoélectrique du premier empilement.

9. Procédé de réalisation selon l'une des revendications 6 à 8, dans lequel, le premier empilement comporte un substrat support supportant les électrodes et la première couche en un matériau piézoélectrique.

10. Procédé de réalisation selon la revendication 9, comportant une étape de structuration du substrat support pour former une cavité sous le résonateur, par exemple par gravure d'une couche sacrificielle.

11. Procédé de réalisation selon l'une des revendications 6 à 10, dans lequel, la première couche en matériau piézoélectrique est réalisée par implantation ionique et fracturation.

## Patentansprüche

1. Verfahren zur Herstellung eines akustischen Resonators, das mindestens einen ersten funktionsfähigen Stapel (E1) und einen zweiten funktionsfähigen Stapel (E2) aufweist, wobei der erste funktionsfähige Stapel mindestens ein erstes Element (2, 4, 6) aufweist, das aus einer ersten Schicht aus piezoelektrischem Material (2) besteht, die zwischen zwei elektrisch leitenden Schichten (4, 6) eingelegt ist, wobei der zweite funktionsfähige Stapel mindestens ein zweites Element (8, 10, 12) aufweist, der aus einer zweiten Schicht aus piezoelektrischem Material (8) besteht, die zwischen einer ersten und einer zweiten Elektrode (1bis, 12) eingelegt ist, wobei das Verfahren Folgendes aufweist:
- Bereitstellen eines ersten funktionsfähigen Stapels, der die erste Schicht aus piezoelektrischem Material sowie die beiden zugehörigen elektrisch leitenden Schichten aufweist,
- Bilden der ersten Elektrode des zweiten funktionsfähigen Stapels auf dem ersten funktionsfähigen Stapel, so dass die erste Elektrode mit den beiden elektrisch leitenden Schichten ausgerichtet ist, und Bilden einer ersten Klebeschicht (118) aus elektrischem Isoliermaterial auf der ersten Elektrode,
- Bereitstellen eines Teils des zweiten funktionsfähigen Stapels, der mindestens eine zweite Klebeschicht (117) aus elektrischem Isoliermaterial und die zweite Schicht aus piezoelektrischem Material umfasst,
- Zusammenfügen des ersten funktionsfähigen Stapels und des Teils des zweiten funktionsfähigen Stapels, der mindestens eine zweite Klebeschicht und die zweite Schicht aus piezoelektrischem Material umfasst, indem die erste und zweite Klebeschicht in Kontakt gebracht werden,
- Bilden der zweiten Elektrode des zweiten funktionsfähigen Stapels, so dass die zweite Elektrode in Ausrichtung mit den beiden elektrisch leitenden Schichten definiert wird,
wobei ein zweites Element mit einem ersten definierten Element eines Stapels ausgerichtet ist, wenn, da das zweite Element in einer Ebene senkrecht zum ersten Element definiert ist, ein Abstand zwischen einer Außenkontur einer Projektion des zweiten Elements in eine Ebene des ersten Elements und einer Außenkontur des ersten Elements kleiner ist als 2 µm.

2. Herstellungsverfahren nach Anspruch 1, wobei die Verbindung zwischen dem ersten funktionsfähigen Stapel und dem Teil des zweiten funktionsfähigen Stapels eine direkte Verklebung ist.

3. Herstellungsverfahren nach Anspruch 1 oder 2, wobei die Klebeschichten aus einem dielektrischen Material bestehen.

4. Herstellungsverfahren nach einem der Ansprüche 1 bis 3, wobei die erste (118) und zweite (117) Klebeschicht so sind, dass sie eine Zwischenschicht (13) mit einer Dicke zwischen 10 nm und 50 nm bilden.

5. Herstellungsverfahren nach einem der Ansprüche 1 bis 4, wobei das Ausrichten der ersten Elektrode mit den beiden elektrisch leitenden Schichten und das Ausführen der zweiten Elektrode, um die zweite Elektrode in Ausrichtung mit den beiden elektrisch leitenden Schichten zu definieren, durch den Einsatz eines Maskenausrichters oder eines Photorepeaters während eines Photolithographieschritts erhalten wird.

6. Herstellungsverfahren nach einem der vorhergehenden Ansprüche, wobei der zweite Stapel ein Wandler ist und der erste Stapel, der die erste Schicht aus piezoelektrischem Material aufweist, Mittel zur Frequenzsteuerung des Wandlers bildet.

7. Herstellungsverfahren nach Anspruch 6, das vor dem Bilden der zweiten Elektrode einen Schritt des Entfernens eines Abschnitts einer bestimmten Dicke aus der zweiten Schicht aus piezoelektrischem Material des zweiten Stapels bis zu einer bestimmten Dicke aufweist.

8. Herstellungsverfahren nach dem vorhergehenden Anspruch, wobei der Schritt des Entfernens eines Abschnitts einer bestimmten Dicke aus der zweiten Schicht aus piezoelektrischem Material durch Frakturieren der zweiten Schicht aus piezoelektrischem Material des zweiten Stapels erhalten wird, wobei die zweite Schicht aus piezoelektrischem Material zuvor einer ionischen Implantation in einer etwas größeren Tiefe als der gegebenen Dicke der ersten Schicht aus piezoelektrischem Material des ersten Stapels unterzogen wurde.

9. Herstellungsverfahren nach einem der Ansprüche 6 bis 8, wobei der erste Stapel ein Trägersubstrat aufweist, das die Elektroden und die erste Schicht aus einem piezoelektrischen Material trägt.

10. Herstellungsverfahren nach Anspruch 9, das einen Schritt des Strukturierens des Trägersubstrats aufweist, um einen Hohlraum unter dem Resonator zu bilden, beispielsweise durch Ätzen einer Opferschicht.

11. Herstellungsverfahren nach einem der Ansprüche 6 bis 10, wobei die erste Schicht aus piezoelektrischem Material durch ionische Implantation und Frakturierung hergestellt wird.

## Claims

1. Production method for an acoustic resonator comprising at least one first functional stack (E1) and a second functional stack (E2), the first functional stack comprising at least one first element (2, 4, 6) comprising a first layer of piezoelectric material (2) interposed between two aligned electrically-conductive layers (4, 6), the second functional stack comprising at least one second element (8, 10, 12) comprising a second layer of piezoelectric material (8) interposed between a first and a second electrode (1à, 12), said method comprising:
- providing a first functional stack comprising the first layer of piezoelectric material as well as the two associated electrically-conductive layers,
- forming the first electrode of the second functional stack on the first functional stack, so as to align the first electrode with the two electrically-conductive layers, and forming a first bonding layer (118) of an electrically-insulating material on the first electrode,
- providing a portion of the second functional stack comprising at least one second bonding layer (117) made of an electrically-insulating material and the second layer of piezoelectric material,
- assembling the first functional stack and the portion of the second functional stack comprising at least a second bonding layer and the second layer of piezoelectric material by contacting the first and second bonding layers,
- forming the second electrode of the second functional stack, so as to define the second electrode in alignment with the two electrically-conductive layers,
a second entity being said to be aligned with a first defined entity of a stack when, the second entity being defined in a layer perpendicular to the first entity, a distance between an outer contour of a projection of the second entity in a plane of the first entity and an outer contour of the first entity is less than 2 µm.

2. Production method according to claim 1, wherein the assembly between the first functional stack and the portion of the second functional stack is a direct bonding.

3. Production method according to claim 1 or 2, wherein the bonding layers are made of a dielectric material.

4. Production method according to one of claims 1 to 3, wherein the first (118) and second (117) bonding layers are such that they form an intermediate layer (13) with a thickness between 10 nm and 50 nm.

5. Production method according to one of claims 1 to 4, wherein aligning the first electrode with the two electrically-conductive layers and making the second electrode so as to define the second electrode in alignment with the two electrically-conductive layers are obtained by implementing a mask aligner or a photorepeater during a photolithography step.

6. Production method according to one of the preceding claims, wherein the second stack is a transducer and the first stack comprising the first layer of piezoelectric material forms frequency control means of said transducer.

7. Production method according to claim 6, comprising, before forming the second electrode, a step of removing a portion with a given thickness from the second layer of piezoelectric material of the second stack up to a given thickness.

8. Production method according to the preceding claim, wherein the step of removing a portion with a given thickness from the second layer of piezoelectric material is obtained by fracturing the second layer of piezoelectric material of the second stack, said second layer of piezoelectric material having previously undergone ion implantation at a depth slightly greater than the given thickness of the first layer of piezoelectric material of the first stack.

9. Production method according to one of claims 6 to 8, wherein the first stack comprises a support substrate supporting the electrodes and the first layer of a piezoelectric material.

10. Production method according to claim 9, comprising a step of structuring the support substrate to form a cavity under the resonator, for example by etching a sacrificial layer.

11. Production method according to one of claims 6 to 10, wherein the first layer of piezoelectric material is made by ion implantation and fracturing.
